# EUROPÄISCHE PATENTANMELDUNG

(11) **EP 0 834 908 A1**
(43) Veröffentlichungstag der Anmeldung: **08.04.1998**
(21) Anmeldenummer: 97890193.2
(22) Anmeldetag: 23.09.1997
(51) Int. Cl.: H01L 21/00, B08B 7/00

(54) **Verfahren und Vorrichtung zum Trocknen von Substraten**

(30) Priorität: 01.10.1996 AT 1734/96
(71) Anmelder: SEZ Semiconductor-Equipment Zubehör für die Halbleiterfertigung AG, 9500 Villach (AT)
(72) Erfinder: Kruwinus, Hans-Jürgen, Dipl.-Ing., 9500 Villach (AT) (AT)
(74) Vertreter: Beer, Manfred, Dipl.-Ing.

(57) **Zusammenfassung**

Zum Trocknen von Halbleitersubstraten, insbesondere von Siliziumwafern im Anschluß an das Spülen nach dem Ätzen wird das Substrat der Wirkung einer Strahlung ausgesetzt, die einen IR- und einen UV-Anteil enthält, wobei der IR-Anteil größer ist als der UV-Anteil. Durch die IR-UV-Bestrahlung wird das Substrat rasch getrocknet und eine Kontamination des Substrates mit unerwünschten Teilchen verhindert bzw. auf ein nichtstörendes Ausmaß beschränkt.

Zum Durchführen des Trocknens mit der IR-UV-Bestrahlung wird eine Anordnung vorgeschlagen, bei der das Substrat unmittelbar aus der Behandlungsflüssigkeit (Spülmedium) zwischen zwei stabförmigen Strahlern, welche die IR-UV-Strahlung abgeben, hindurch bewegt wird.

## Beschreibung

Die Erfindung betrifft ein Verfahren und Vorrichtungen zum Trocknen von Substraten, insbesondere von Halbleitersubstraten, wie Siliziumwafer, Galliumarsenidwafer, aber auch von Glas- und Quarzsubstraten, Metallsubstraten und Compactdiscs.

Die gemäß der Erfindung mit dem Ziel des Trocknens zu behandelnden Substrate müssen nicht ausschließlich rund bzw. scheibenförmig sein, sondern können eine weitestgehend beliebige Form besitzen. Bevorzugtes Einsatzgebiet ist aber das Trocknen von scheibenförmigen Substraten.

Besonders im Vordergrund steht bei der Erfindung das Trocknen von Halbleitersubstraten, wie Siliziumwafer bzw. Halbleitersubstraten auf Basis von Galliumarsenid.

Beim Trocknen von Siliziumwafer ist es besonders nachteilig, daß während des Trockenverfahrens eine für den Halbleiterwafer nachteilige Partikelzunahme auftritt, also nicht rückstandsfrei getrocknet werden kann. Dies gilt für alle bekannten Verfahren zum Trocknen, die mit Abschleudern, mit Einwirken von Isopropanoldampf oder mit schnellem Drehen des Wafers um eine zu dessen Fläche senkrechte Achse arbeiten.

Ursache für die erwähnte, nachteilige Partikelbildung ist bei Siliziumwafern, daß Wasser mit Silizium zu siliziumoxidähnlichen (quarzartigen) Verbindungen reagiert.

Der Erfindung liegt die Aufgabe zugrunde, Flüssigkeitsreste, insbsondere Reste von deionisiertem Wasser, die sich von vorhergegangenen Behandlungsschritten auf der Oberfläche des Substrates vornehmlich des plattenförmigen Gegenstandes, insbesondere des Siliziumwafers, befinden können, möglichst rasch zu entfernen, so daß die erwähnte Partikelbildung nicht oder nicht in störendem Ausmaß auftritt.

Die Aufgabe der Erfindung wird durch ein Verfahren mit den Merkmalen des Anspruches 1 gelöst.

Das erfindungsgemäße Verfahren dient vornehmlich zum Trocknen von scheibenförmigen Substraten der Halbleitertechnik, insbesondere von Siliziumwafern, nach einer Behandlung mit einer Flüssigkeit, insbesondere nach dem Spülen im Anschluß an eine Ätzbehandlung, wobei das Substrat mit einer Strahlung behandelt wird, die einen Infrarot-Anteil und einen Ultraviolett-Anteil enthält.

Bei der Erfindung wird die Schwierigkeit beim Entfernen von Flüssigkeitsresten von Oberflächen die darin besteht, die Oberfläche so zu behandeln, daß weder in den Flüssigkeitsresten befindliche Verunreinigungen nach dem Entfernen der Flüssigkeit auf der Oberfläche des Substrates zurückbleiben, noch das Material des Substrates durch die Wärmeeinwirkung während der Trockungsbehandlung verändert wird oder durch die Behandlung weitere Verunreinigungen aufgebracht werden, auf ebenso einfache wie wirksame Weise gelöst.

Bei Anwendung des erfindungsgemäßen Verfahrens werden die Oberflächen von insbesondere plattenförmigen Gegenständen so behandelt, daß sich auf der Oberfläche des Substrates befindliche Flüssigkeitsreste von der Oberfläche ohne Berührung derselben entfernt werden, und daß weder Verunreinigungen zurückbleiben, noch die Struktur des Werkstoffes des insbesondere scheiben- oder plattenförmigen Substrates durch die Behandlung verändert wird.

Weitere Einzelheiten und Merkmale des erfindungsgemäßen Verfahrens und der erfindungsgemäßen, zum Durchführen des Verfahrens vorgeschlagenen Vorrichtungen (Anordnungen) ergeben sich aus der nachstehenden Beschreibung von in den Zeichnungen gezeigten Ausführungsbeispielen und den Beispielen für das erfindungsgemäße Verfahren.

Es zeigt:
Fig. 1 weitgehend schematisiert eine erste Anordnung zum Durchführen des erfindungsgemäßen Verfahrens,
Fig. 2 eine zweite Ausführungsform und
Fig. 3 eine Ausführungsform mit zwei Strahlern,
Fig. 4 die relative spektrale Strahlungsverteilung eines beim erfindungsgemäßen Verfahren bevorzugt eingesetzten Halogen-Infrarotstrahlers und die
Fig. 5 bis 7 Diagramme zu dem Versuch und zu den Ausführungsbeispielen 1 und 2.

Bei dem erfindungsgemäßen Trockenverfahren wird das zu trocknende Substrat mit einer Strahlung behandelt, die sowohl einen Infrarot (IR)-Anteil als auch einen Ultraviolett (UV)-Anteil enthält, wobei der Infrarotanteil vorzusgweise überwiegt und das Verhältnis IR-Anteil:UV-Anteil im Bereich zwischen 50:1 bis 20:1 liegen kann.

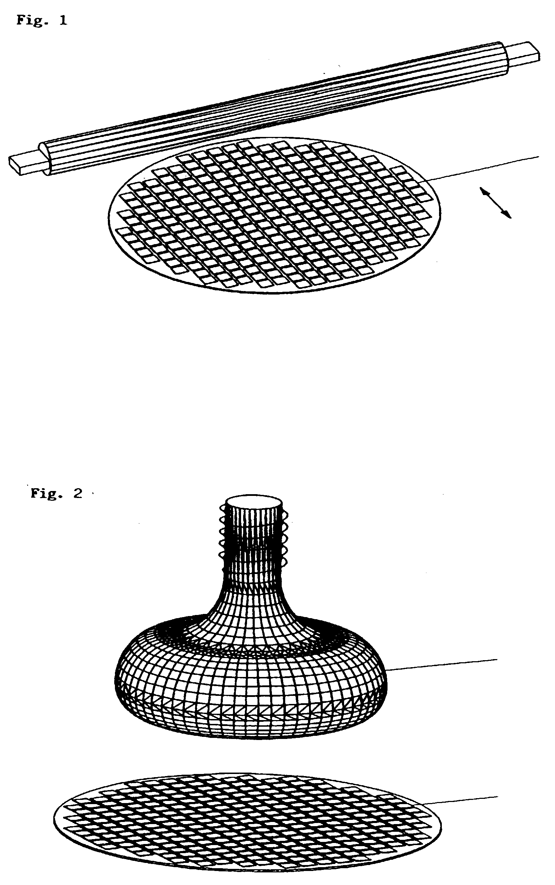

Bei der in Fig. 1 gezeigten Anordnung wird das zu behandelnde Substrat - im Beispiel ein Siliziumwafer - relativ zu dem Strahler bewegt, wobei es im wesentlichen horizontal liegend ausgerichtet ist. Es ist auch denkbar, nebeneinander mehrere zueinander parallel ausgerichtete Strahler vorzusehen, so daß durch Kombination mit der Bewegung des Substrates relativ zu dem wenigstens einen, stabförmigen Strahler eine gleichmäßige Behandlung der Oberfläche erzielt wird.

Grundsätzlich ist es auch denkbar, daß die Strahler relativ zu dem zu trocknenden Substrat bewegt werden, da es für die in Fig. 1 gezeigte Variante im wesentlichen auf eine Relativbewegung zwischen Strahlungsquelle und Substrat ankommt, um ein gleichmäßiges Trocknen zu erzielen.

Bei der in Fig. 2 gezeigten Ausführungsform ist der Strahler so ausgebildet, daß er eine der Kontur des zu trocknenden Substrates - hier eines Siliziumwafers - angepaßte Form aufweist, also im Ausführungsbeispiel von Fig. 2 etwa kreisrund ist und im übrigen eine angenähert birnenförmige Gestalt besitzt. Bei der in Fig. 2 ge zeigten Ausführungsform ist es nicht mehr erforderlich, das Substrat während des eigentlichen Trocknens relativ zu dem Strahler zu bewegen.

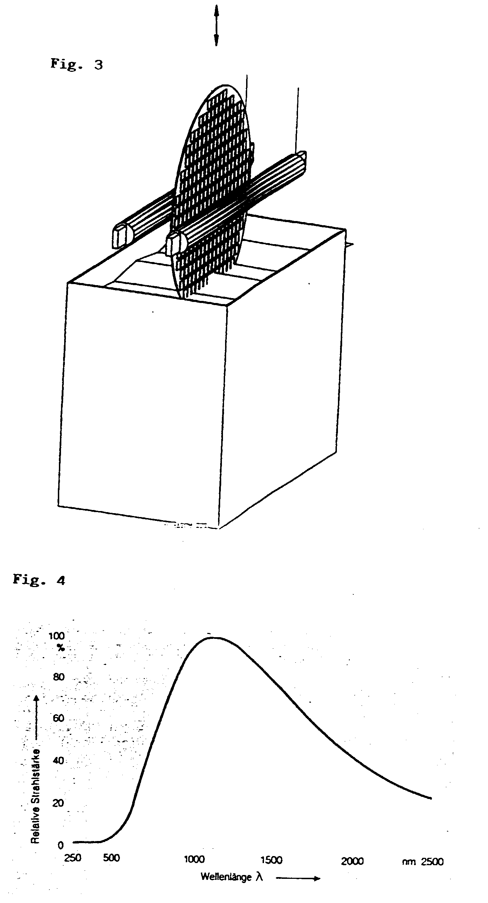

Bei der in Fig. 3 gezeigten Ausführungsform wird ein aus einem Behälter, in dem ein Behandlungsmedium enthalten ist, nach oben entferntes Substrat (hier ein Halbleiterwafer, insbesondere ein Siliziumwafer) unmittelbar nach dem Austritt aus dem Behandlungsmedium zwischen zwei parallel ausgerichteten Strahlern durchbewegt, so daß das Trocknen unmittelbar nach dem Entfernen des Substrates aus dem Behandlungsmedium erfolgt. Bei der Ausführungsform der Vorrichtung nach Fig. 3 können auf einer oder beiden Seiten der Bewegungsbahn des zu trocknenden Substrates auch mehrere zueinander parellele Strahler übereinander angeordnet sein.

Bei allen Ausführungsformen kann die Behandlungszeit zwischen 5 und 60 Sekunden liegen. Bei der Ausführungsform von Fig. 2 sind auch Behandlungszeiten zwischen 1 und 4 Sekunden möglich. Der Abstand zwischen Substrat und Strahler kann bei den in Fig. 1 und 2 gezeigten Ausführungsformen 1 bis 150 mm betragen, wogegen bei der in Fig. 3 gezeigten Ausführungsform der Abstand der Strahler voneinander 2 bis 150 mm beträgt und bevorzugt das Substrat genau zwischen den Strahlern durchgeführt wird, so daß diese von der Oberfläche des Substrates einen Abstand zwischen 1 und 75 mm angeordnet sind.

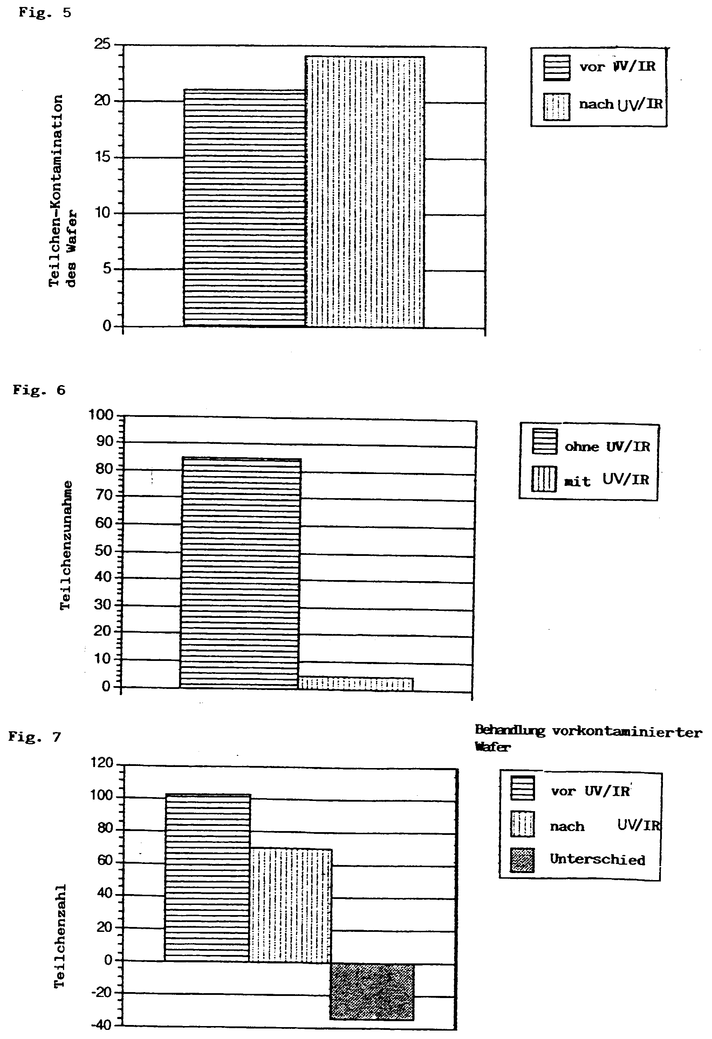

Die in dem erfindungsgemäßen Verfahren bevorzugt eingesetzten Strahler sind Halogen-Infrarot-Strahler, die eine Strahlung abgeben, deren relative spektrale Strahlungsverteilung beispielsweise der Strahlungsverteilung in Fig. 4 entspricht. In diesem Ausführungsbeispiel beträgt der Anteil an Infrarotstrahlung (also ab etwa 1100 Nanometer Wellenlänge) über 90 %, wogegen der UV-Bereich (unter ca. 50 Nanometer Wellenlänge) bei etwa 2 bis 5 % liegt. Im Rahmen der Erfindung verwendbare Strahler sind Halogenlampen oder Quecksilberdampflampen.

Dies sind jedoch nur spezielle und im Rahmen der Erfindung bevorzugte Verhältnisse zwischen dem UV- und IR-Anteil in der vom Strahler beim Trocknen des erfindungsgemäßen Verfahrens abgegebenen Strahlung. Allgemein kann gesagt werden, daß erfindungsgemäß ein Überwiegen des IR-Anteils gegenüber dem UV-Anteil in der Strahlung bevorzugt ist und die besten Ergebnisse liefert.

Versuch:
In diesem Versuch wurde die Reinheit der IR-UV-Strahlungsquelle und der Versuchsanordnung zum Handhaben von Siliziumwafern überprüft.

Die Arbeitsbedingungen bei diesem Versuch waren folgende:
Substrat: Siliziumwafer, Durchmesser 6 Zoll.
IR-UV-Strahler: Strahlungsverteilung gemäß Fig. 4.
Abstand Substrat-Strahler: 15 mm.
Einwirkdauer: 18 sec.
Flüssigkeit, die durch Trocknen entfernt wurde: Wasser.
Vorbehandlung des Substrates: mit 5%-iger Flußsäure.

Aus dem in Fig. 5 wiedergegebenen Diagramm ist zu entnehmen, daß die Teilchenkontamination auf dem Wafer nach Bestrahlen des Wafers lediglich um drei Teilchen angestiegen war. Dies, obwohl es sich um ein handbetätigtes Beschicken und Entnehmen handelte.

### Beispiel 1:

In diesem Beispiel wurde das teilchenoptimierte HF-Ätzen (rein)-Verfahren mit und ohne zusätzliche IR-UV-Bestrahlung beim Trocknen untersucht. Die Zahl der Teilchen auf dem untersuchten Wafer betrug < 10 Teilchen 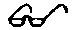 0,12 µm².

Die Arbeitsbedingungen bei diesem Beispiel waren folgende:
Substrat: Siliziumwafer, Durchmesser 6 Zoll.
IR-UV-Strahler: Strahlungsverteilung gemäß Fig. 4.
Abstand Substrat-Strahler: 15 mm.
Einwirkdauer: 18 sec.
Flüssigkeit, die durch Trocknen entfernt wurde: Wasser.
Vorbehandlung des Substrates: mit 5%-iger Flußsäure.

In dem in Fig. 6 wiedergegebenen Diagramm ist die Teilchenzunahme ohne IR-UV-Bestrahlung beim Trocknen der Teilchenzunahme gegenübergestellt, die auftritt, wenn beim Trocknen mit IR-UV-Bestrahlung behandelt wird. Es ist bezeichnend, daß bei Verwendung der IR-UV-Bestrahlung beim Trocknen die Kontamination lediglich um fünf Teilchen zunahm.

### Beispiel 2:

In diesem Beispiel wurde der Einfluß von IR-UV-Bestrahlung auf einen vorher bereits mit Teilchen kontaminierten Siliziumwafer untersucht. Die Ergebnisse sind in dem Diagramm von Figur 7 wiedergegeben.

Die Arbeitsbedingungen bei diesem Beispiel waren folgende:
Substrat: Siliziumwafer, Durchmesser 6 Zoll.
IR-UV-Strahler: Strahlungsverteilung gemäß Fig. 4.
Abstand Substrat-Strahler: 15 mm.
Einwirkdauer: 18 sec.
Flüssigkeit, die durch Trocknen entfernt wurde: Wasser.
Vorbehandlung des Substrates: mit 5%-iger Flußsäure.

Es ist dem Diagramm von Fig. 7 zu entnehmen, daß die Kombination einer Ätzbehandlung mit Flußsäure mit einer IR-UV-Strahlung zum nachfolgenden Trocknen eine Verminderung der Teilchen, mit welchen der Wafer kontaminiert war, zur Folge hatte. Dies ist insoferne überraschend, da bislang Ätzverfahren mit Flußsäure immer zu einer Teilchenzunahme geführt haben.

Zusammenfassend zeigen der Versuch und die Beispiele, daß durch das Trocknen mit IR-UV-Bestrahlung das Ausmaß der Kontamination von Substraten, insbesondere von Siliziumwafern mit (verunreinigenden) Teilchen verhindert wird und daß durch Trocknen mit IR-UV-Strahlung nach Ätzen mit Flußsäure sogar eine Verringerung des Ausmaßes der Kontamination kontaminierter Wafer ereicht werden konnte.

Zusammenfassend kann ein Ausführungsbeispiel der Erfindung wie folgt dargestellt werden:

Zum Trocknen von Halbleitersubstraten, insbesondere von Siliziumwafern im Anschluß an das Spülen nach dem Ätzen wird das Substrat der Wirkung einer Strahlung ausgesetzt, die einen IR- und einen UV-Anteil enthält, wobei der IR-Anteil größer ist als der UV-Anteil. Durch die IR-UV-Bestrahlung wird das Substrat rasch getrocknet und eine Kontamination des Substrates mit unerwünschten Teilchen verhindert bzw. auf ein nichtstörendes Ausmaß beschränkt.

Zum Durchführen des Trocknens mit der IR-UV-Bestrahlung wird eine Anordnung vorgeschlagen, bei der das Substrat unmittelbar aus der Behandlungsflüssigkeit (Spülmedium) zwischen zwei stabförmigen Strahlern, welche die IR-UV-Strahlung abgeben, hindurch bewegt wird.

## Patentansprüche

1. Verfahren zum Trocknen von Substraten, insbesondere von scheibenförmigen Substraten der Halbleitertechnik, insbesondere Siliziumwafer, dadurch gekennzeichnet, daß man das Substrat mit einer Strahlung behandelt, die einen IR-Anteil und einen UV-Anteil enthält.

2. Verfahren nach Anspruch 1, dadurch gekennzeichnet, daß man das Substrat mit einer Strahlung behandelt, deren IR-Anteil größer ist als der UV-Anteil.

3. Verfahren nach Anspruch 1 oder 2, dadurch gekennzeichnet, daß man mit einer Strahlung behandelt, bei der das Verhältnis IR-Anteil:UV-Anteil zwischen 50:1 bis 20:1 liegt.

4. Verfahren nach einem der Ansprüche 1 bis 3, dadurch gekennzeichnet, daß man das Substrat mit einer Strahlung behandelt, deren relative Strahlungsstärke dem in Fig. 4 gezeigten Diagramm entspricht.

5. Verfahren nach einem der Ansprüche 1 bis 4, dadurch gekennzeichnet, daß man das Substrat im Falle eines scheibenförmigen Substrates auf beiden Seiten mit der IR-UV-Strahlung behandelt.

6. Anordnung zum Durchführen des Verfahrens nach einem der Ansprüche 1 bis 5, dadurch gekennzeichnet, daß wenigstens ein Strahler vorgesehen ist, der eine Strahlung abgibt, die einen IR-Anteil und einen UV-Anteil enthält, und daß eine Einrichtung vorgesehen ist, um eine Relativbewegung zwischen Strahler und Substrat auszuführen.

7. Anordnung nach Anspruch 6, dadurch gekennzeichnet, daß der Strahler stabförmig ist.

8. Anordnung nach Anspruch 7, dadurch gekennzeichnet, daß mehrere nebeneinander und parallel zueinander ausgerichtete, stabförmige Strahler vorgesehen sind.

9. Anordnung nach einem der Ansprüche 6 bis 8, dadurch gekennzeichnet, daß zum Trocknen von scheibenförmigen Gegenständen wenigstens zwei Strahler vorgesehen sind und daß die Einrichtung zum Ausführen der Relativbewegung zwischen Strahler und Substrat das Substrat zwischen den Strahlern bewegt.

10. Anordnung nach Anspruch 9, dadurch gekennzeichnet, daß zwei zueinander parallel ausgerichtete Reihen von Strahlern vorgesehen sind.

11. Anordnung nach einem der Ansprüche 6 bis 10, dadurch gekennzeichnet, daß der Strahler unmittelbar über einer Kammer zum Behandeln des Substrates, insbesondere zum Spülen des Substrates, angeordnet ist.

12. Anordnung zum Durchführen des Verfahrens nach einem der Ansprüche 1 bis 5, dadurch gekennzeichnet, daß wenigstens ein Strahler vorgesehen ist, der eine Strahlung abgibt, die einen IR-Anteil und einen UV-Anteil enthält, und daß die die Strahlung abgebende Fläche des Strahlers an die Umrißform des Substrates angepaßt ist.

13. Anordnung nach Anspruch 12, dadurch gekennzeichnet, daß zum Behandeln von scheibenförmigen Substraten ein Strahler mit scheibenförmiger Strahlungsfläche vorgesehen ist.
